Europäisches Patentamt

European Patent Office

Office européen des brevets

(11) Publication number: **0 357 199 B1**

## EUROPEAN PATENT SPECIFICATION

(45) Date of publication of patent specification: **30.03.94** (51) Int. Cl.⁵: **G01D 5/16**

(21) Application number: **89307121.7**

(22) Date of filing: **13.07.89**

(54) **Improved position sensor.**

(30) Priority: **23.12.88 US 289641**
**08.08.88 US 229396**

(43) Date of publication of application:
**07.03.90 Bulletin 90/10**

(45) Publication of the grant of the patent:
**30.03.94 Bulletin 94/13**

(84) Designated Contracting States:
**DE FR GB IT NL SE**

(56) References cited:
**EP-A- 0 151 002**
**WO-A-86/00877**
**FR-A- 2 194 952**
**US-A- 3 898 359**
**US-A- 3 900 814**

**SOVIET PHYSICS SEMICONDUCTORS, vol.
21, no. 8, August 1987, New York,US, pages
900-901; A.T. Gorelenok et al: "Magnetoresis-
tive emf of a quasitwo-dimensional electron
gas in InGeAs/InP heterostructures"**

(73) Proprietor: **GENERAL MOTORS CORPORA-
TION**
**General Motors Building**
**3044 West Grand Boulevard**
**Detroit Michigan 48202(US)**

(72) Inventor: **Morelli, Donald Thomas**
**860 Spring Drive**
**Northville, MI 48167(US)**
Inventor: **Partin, Dale Lee**
**37728 Alper Drive**
**Sterling Heights MI 48077(US)**
Inventor: **Green, Louis**
**801 Bridgestone**
**Rochester Hills, MI 48309(US)**
Inventor: **Heremans, Joseph Pierre**
**2640 Lanergan**
**Troy, MI 48084(US)**
Inventor: **Thrush, Christopher Mark**
**54800 Arrowhead**
**Utica MI 48087(US)**

(74) Representative: **Denton, Michael John et al**
**Patent Section**
**1st Floor**
**Gideon House**
**28 Chapel Street**
**Luton Bedfordshire LU1 2SE (GB)**

EP 0 357 199 B1

**Description**

Co-pending Patent Applications

This patent application is related to the following concurrently filed European patent applications Numbers 89307123.3 (EP-A-0 357 200); 89307122.5 (EP-A-0 375 108); & 89307120.9 (EP-A-0 375 107), which are based on the following earlier filed United States patent applications USSN 229,396, USSN 289,634 and USSN 289,646 respectively.

Field of the Invention

This invention relates to a position sensor as specified in the preamble of claim 1, for example as disclosed in EP-A-0151002. More particularly, it relates to an improved magnetic field sensing system having an improved magnetoresistive sensor for detecting changes in magnetic flux passing through a magnetic flux sensitive element.

Background of the Invention

This invention is a further improvement on the improved magnetic field sensing system already being described and claimed in the above-identified European patent application 89307123.3 (EP-A-0 357 200A).

The need for accurately and easily sensing position, speed or acceleration is growing, particularly in the automotive field. Anti-lock braking systems, traction control systems, electric power steering, four-wheel steering and throttle control are examples of functions that can use such sensing. Such applications not only require accuracy and precision but frequently involve severe environments. Cost of such systems is an important factor too.

For such applications, it is desirable to have a position sensor (speed and acceleration can be derived from a position signal) that is rugged and reliable, small and inexpensive, capable of low (including zero) speed sensing and which is relatively immune to electromagnetic field interference from other control systems used in an automobile.

A well-known form of position sensor is a semi-conductor magnetoresistive sensor. Such a sensor comprises a magnetic circuit that includes two basic parts. One of these parts, typically kept stationary, includes a semi-conductive sensing element that is sensitive to the magnetic flux density passing through its surface, and further includes a permanent magnet for creating a reference flux. The other of the two parts, termed the exciter, includes a high magnetic permeability element with a series of teeth that moves with relation to the stationary element for changing the reluctance of the magnetic circuit and for causing the magnetic flux through the sensing element to vary in a fashion corresponding to the position of the teeth.

Such a sensor is sensitive to the magnetic flux density rather than to the rate of flux density change and so it does not have a lower speed limit. This also makes it less sensitive to E.M.I. Moreover, its response is predictably related to the distribution of flux density over the surface of the sensing element.

Typically, the stationary part includes a magnetoresistive element including a semi-conductive element whose resistance varies with the magnetic flux density passing through it in controllable fashion so that an electrical output signal can be derived. Moreover, when this magnetoresistor is produced from a high electron mobility semi-conductor, such as compound semi-conductors like indium antimonide or indium arsenide, a large electrical output signal can be available. If the output signal is sufficiently large, there is the possibility of providing an output signal that requires little or no further amplification, a factor of considerable advantage.

It is desirable to have a position sensor of high sensitivity so that a large electrical output signal can be produced efficiently, and which is of easy manufacture so that it can be made reliably and at low cost.

The magnitude of the flux variations in the sensing element for a given change in position of the exciter is an important factor in determining the sensitivity of the sensor. Accordingly, a variety of designs have been attempted hitherto to maximize the change in the flux density through the sensor in response to a given change in exciter position. Typically, these attempts involved including a flux guide for the permanent magnet included in the stationary part of the magnetic circuit to provide a return path for the magnetic field of the magnet. Additionally, sometimes a field concentrator of commensurate size has been provided contiguous to the magnetoresistive element to concentrate flux through the magnetoresistive element.

However, for example, such techniques have typically produced magnetic circuit sensitivities no higher than about five percent for a typical exciter design having a three millimetre tooth pitch and one millimetre gap, where the sensitivity is defined as the difference between the maximum and minimum flux densities sensed divided by the mean flux density sensed (half the sum of the maximum and minimum flux densities sensed).

Two companion European patent applications are being concurrently filed, based upon USSN 289,634 and USSN 289,646 which are more fully identified above. These two companion patent applications describe the fabrication and properties of a new type of magnetoresistor thin film element. The patent application based upon USSN 289,634 details the process of growing a thin film of indium arsenide (InAs), a narrow-gap semi-conductor, on a semi-insulating indium phosphide (InP) substrate, and shows that this device has a rather large sensitivity of electrical resistance to magnetic fields. The patent application based upon USSN 289,646 outlines various methods of enhancing the sensitivity of the device on the basis of the existence of a thin surface layer (known as an accumulation or inversion layer) of high density, high mobility electrons. Such electron accumulation or strong inversion layers can be induced in a variety of semi-conductor thin film materials. While the devices described therein could be used in a wide variety of magnetic field sensing applications without significant further development, the application of these magnetoresistors as position sensors in more stringent operating conditions (such as those which exist in an automobile) requires interfacing the magnetoresistor with a suitable sensing system.

The inventors have recognized that the type of magnetic circuit disclosed in the European patent application corresponding to USSN 229,396 is so effective in concentrating the magnetic field that less sensitive magnetoresistors may still work well enough to be useful at some applications. In addition, the inventors have recognized that some of the less sensitive magnetoresistor materials are magnetically sensitive at higher temperatures. The inventors have also recognized that the improved magnetoresistor concepts of the patent applications based on USSN 289,634 and USSN 289,646 provide enhancement to less magnetically sensitive materials. The inventors have thus recognized that the combination of all these concepts could provide especially striking benefits. This patent application specifically describes and claims that combination.

There are several reasons why the improved magnetoresistors described in the patent applications based on USSN 289,634 and USSN 289,646 would be especially desirable for use in such a sensing system. The reasons will not be mentioned in order of importance. First, extreme compactness of these sensors make their use ideal in any sensing location, regardless of the space limitations. Secondly, their improved sensitivity to magnetic field affords the designer a large amount of freedom in the placement of the sensor with respect to the exciter wheel. This means that the air gap between exciter and sensor can be larger than for a less sensitive device without any diminution in magnitude of the electrical signal. This could prove to be important in applications where vibration and thermal expansion problems limit the degree of proximity of the sensor to the exciter wheel. Also, the outstanding temperature stability of the sensitivity of the improved magnetoresistors will allow their application in extreme temperature environments, such as automotive anti-lock braking systems, in which temperatures can range from -50°C to +200°C. Other applications may require operation at temperatures as high as +300°C. The inventors believe that the enhancement to system sensitivity afforded by the magnetic circuit concepts disclosed in the European patent application corresponding to USSN 229,396 and the enhancement to magnetoresistor sensitivity afforded by the concepts disclosed in the patent applications based on USSN 289,634 and USSN 289,646, in combination, makes a wider group of semi-conductor materials now available for use in magnetic field sensing. Materials that were previously considered as unacceptable now can be used, and will provide acceptable performance at much higher temperature. This expands the range of applications where such sensing is practical, and provides other benefits as well.

Accordingly, the inventors consider that the combination proposed in this patent application is especially attractive for automotive applications as part of linear or rotary position measurement systems. The sensitivity to magnetic field and high thermal stability of these sensors would be especially beneficial.

Summary of the Invention

A position sensor according to the present invention is characterised by the features specified in claim 1. Advantageous embodiments of the invention are characterised by the features specified in the dependent claims 2 to 10.

The novel type of magnetoresistor significantly improves the circuit. The combination is simple and planar in configuration, which makes it amenable for batch processing with a consequent saving in manufacturing cost. Moreover, it makes possible attainment of sensitivities and/or sensing at higher temperatures appreciably higher than prior-art structures.

In particular, the novel magnetic circuit employs a stationary part that comprises a permanent magnet whose width is several times wider than that of the magnetic sensing element and, advantageously, at least about one and one half times the pitch of the exciter teeth. The sensing element is a magnetoresistor having an accumulation layer on its sensing area surface. Moreover, in the preferred embodiment for further improvement in the sensitivity, the surface of the magnet adjacent to which the teeth pass is provided with a thin layer of a magnetic material of high permeability. The magnetic sensing element advantageously is centred on this magnetic layer and is as described in the patent applications based upon USSN 289,634 or USSN 289,646. Additionally, the width of the magnetic sensing element is desirably narrow for maximum sensitivity, but is wide enough to have a suitable resistance for good impedance matching with the electrical circuit used to detect the change in properties resulting from the magnetic flux being sensed. Preferably any flux guide or field concentrator is avoided by using a magnet of adequate strength.

It is characteristic of this magnetic circuit that the passing teeth of the exciter essentially vary only the spatial distribution of the magnetic flux density along the width of the magnet for creating sharp local flux density variations that can be readily sensed by the sensing element, while the total flux density passing through the thin ferromagnetic layer remains essentially constant. By way of contrast, in prior-art magnetic circuits, the passing teeth of the exciter vary the circuit reluctance and consequently vary the total magnetic flux in the circuit.

The invention will be better understood from the following more detailed description taken with the accompanying drawings.

## Brief Description of the Drawings

Figure 1A is a schematic view of a magnetoresistor, showing its electrical current fLow lines when no magnetic field is applied to it.

Figure 1B is a schematic view of a magnetoresistor, showing how the electrical current flow lines shown in Figure 1A are re-directed in the plane of a major surface of the magnetoresistor when a magnetic field is applied perpendicular to that surface.

Figure 2 is an isometric view showing a magnetoresistor having two integral sensing areas electrically in parallel.

Figure 3 is a three-dimensional or contour plot showing the change of electrical resistance in a single element larger band gap semi-conductor magnetoresistor with changes in temperature and magnetic field strength.

Figure 4 is a two-dimensional plot of the fractional magnetoresistance over a wider temperature range than shown in Figure 3.

Figure 5 is a two-dimensional plot showing change in resistance with no magnetic field applied over a wider temperature range than shown in Figure 3.

Figure 6 is an elevational view showing a semi-conductor film in a pattern for providing a series-connected plurality of sensing areas integrated in a single magnetoresistor.

Figure 7A is an elevational view showing a metallization pattern for superposition on the Figure 6 pattern.

Figure 7B is an elevational view showing the Figure 7A metallization pattern superimposed on the Figure 6 semi-conductor pattern to delineate the plurality of sensing areas.

Figure 8 is a three-dimensional or contour plot showing the change of electrical resistance of a multiple sensing area magnetoresistor such as shown in Figure 7B.

Figures 9 and 10 are two-dimensional electron energy to depth plots showing how electrons could be confined in an accumulation layer under special layers on a surface of the sensing area of the magnetoresistor.

Figures 11A, 11B, and 11C are schematic views showing a magnetoresistor having a gate electrode over each of a plurality of sensing areas to electrically induce an accumulation layer in each sensing area. In Figures 11B and 11C, the gate electrodes are electrically biased internally, by two different techniques.

Figure 12 is a schematic view showing a magnetoresistor having accumulation layers not only in the sensing areas but also as conductors making electrical contact to the edges of the sensing areas.

Figure 13 shows a typical magnetic circuit of a prior-art position sensor of the type using a flux guide return path;

Figure 14 shows a magnetic circuit of a position sensor in accordance with a preferred embodiment of the present invention;

Figure 15 shows in more detail a stationary sensing portion of the magnetic circuit shown in Figure 14;

Figures 16A and 16B show the magnetic circuit of Figure 14 for two different positions of its permanent magnet relative to the exciter; and

Figures 17 and 18 are plots useful in discussing design considerations of the invention.

Description of the Preferred Embodiments

As indicated above, a new approach to making magnetoresistors is described and claimed in the patent applications based upon USSN 289,634 and USSN 289,046. It was found that if an accumulation layer is induced in the surface of an extremely thin film of semi-conductive material, the properties of the accumulation layer relevant to magnetic sensitivity can dominate over those of the remainder of the film.

Such accumulation layers can make higher band gap semi-conductor materials useful in magnetosensors. Such materials can be used at higher operating temperatures than lower band gap semi-conductive material, such as indium antimonide. However, it may even enhance the sensitivity of indium antimonide enough to allow it to be used at higher temperatures. In this discussion the term "accumulation layer" is used. In this patent application, the term "accumulation layer" is intended to also include an inversion layer, unless otherwise noted.

The accumulation layer is especially directed to use in magnetoresistors made of higher band gap semi-conductive materials. However, it is expected to be beneficial in magnetoresistors made of still other semi-conductive materials.

A typical magnetoresistor element consists of a slab of semi-conductor, typically rectangular in shape, through which a current is passed. Such a magneto resistor is described by S. Kataoka in "Recent development of Magnetoresistive Devices and Applications," Circulars of Electrotechnical Laboratory No. 182, Agency of Industrial Science and Technology, Tokyo (December 1974).

In the absence of a magnetic field, the current lines go from one injecting electrode to the other in parallel lines (see Figure 1A). This flow is between electrodes along the top and bottom edges of the rectangle in Figure 1A. The configuration (a rectangle in this example) is chosen so that an applied magnetic field, perpendicular to the slab, increases the current line trajectory (see Figure 1A). The magnetic field perpendicular to the plane of the rectangle thus lengthens the current flow lines. The longer length leads to higher electrical resistance, so long as the resulting lateral voltage difference is electrically shorted, as shown, by the top and bottom edge electrodes.

The best configuration for this effect to occur is one where the current injecting electrodes are along the longest side of the rectangle, and the ratio of this dimension ("width") to the shortest dimension ("length") is as large as possible. The length of the short edges of the rectangular sensing area is preferably about 30% - 50% of the length of the long edges of the rectangular sensing area. Such an optimal device configuration hence leads to a very low resistance. Kataoka teaches that the magnetic field sensitivity of such devices is best when the devices are made out of semi-conductors with as large a carrier mobility as possible. The resistivity of such devices is made less temperature-dependent when the semi-conductor material contains a large donor concentration, giving a large carrier density. These last two constraints imply that semi-conductors with high electrical conductivity are best suited for practical applications.

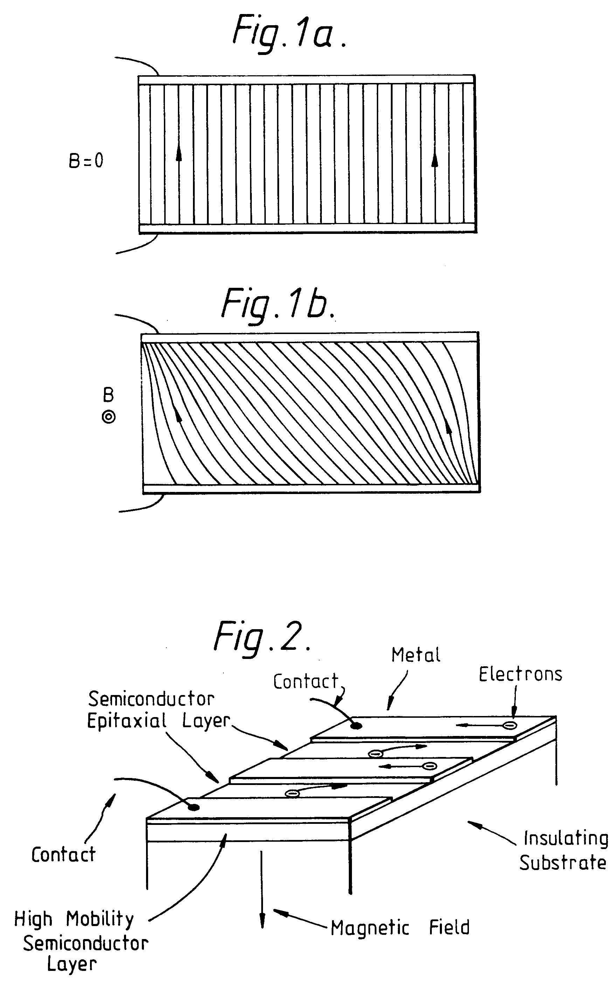

Combined with the geometrical restrictions described earlier, one can deduce that the final magnetoresistor element will have a low resistance. This has a practical drawback. Under a constant voltage, the power dissipated by the device is proportional to the inverse of the resistance. To limit ohmic heating (which would limit the operational temperature range of the sensor, if not destroy the sensor itself) whilst maintaining a large voltage output during sensor interrogation, it is desirable that a magnetoresistive element have a resistance around 1kW. The inventors consider this to typically be equivalent to a resistance of about 300W-3kW. A number of ways have been proposed to achieve such resistances. For example, as Kataoka has pointed out, one can put a number of elementary devices in series. Making a plurality of sensing areas as integral parts of a single element is shown in Figure 2. Whilst only two sensing areas (i.e., devices) are shown, one could make an element with tens or hundreds of integral sensing areas (i.e., devices).

If the metal-semi-conductor (magnetic-field independent) interfacial contact resistance of one such elementary device is an appreciable fraction of the semi-conductor resistance of this elementary device, it will lower the sensitivity to a magnetic field. Thus, metals must be deposited which have a very low metal-semi-conductor interfacial contact resistance to avoid this sensitivity degradation. In most cases it would be preferable that the interfacial contact resistance between the sensing area and its electrodes be 10-100 times less than the resistance of the sensing area between those electrodes. Another option which alleviates the problem of low magnetoresistor device resistance has been to use active layers that are as thin as possible. This has been done by thinning wafers of indium antimonide (InSb), which were sliced from bulk ingots, down to thicknesses as small as 10 micrometres. The wafer thinning process is a very difficult process, since any residual damage from the thinning process will lower the electron mobility. Reducing

5

electron mobility will decrease the sensitivity to a magnetic field of devices made from this material.

Another approach has been to deposit films of InSb onto an insulating substrate. On the other hand, in this latter case, the electron mobility of the resulting films is reduced to a fraction of that of bulk InSb. This reduction occurs because of defects in the film. With typical mobilities of 20,000 $cm^2V^{-1}sec^{-1}$, these films produce devices with greatly reduced sensitivity to a magnetic field compared to devices made from bulk InSb. The usual device structure for the prior magnetoresistors made from a film is schematically shown in Figure 2.

The great majority of the prior work until now has focused on InSb. This can be understood from the data in the following Table I.

TABLE I.

| Potential Magnetoresistor Materials at 300°K | | | |
|---|---|---|---|
| Semi-conductive Material | Maximum Electron Mobility ($cm^2V^{-1}sec^{-1}$) | Crystal Lattice Constant (A) | Energy Band Gap (eV) |
| InSb 6.478 | 78,000 | 6.478 | 0.17 |
| $Bi_{1-x}Sb_x$ (x 0.2) | 32,000 | 6.429(Bi) | 0-0.02 |
| InAs | 32,000 | 6.058 | 0.35 |
| $In_{0.53}Ga_{0.47}As$ (on InP) | 14,000 | 5.869 | 0.75 |
| GaAs | 8,000 | 5.654 | 1.4 |
| GaSb | 5,000 | 6.095 | 0.68 |
| InP | 4,500 | 5.869 | 1.27 |

Since the magnetoresistance effect is proportional to the square of the electron mobility for small magnetic fields, InSb is highly preferable. However, the difficulty of growing compound semi-conductors in general, and the fact that there is no suitable, lattice-matched, insulating substrate upon which it may be grown led the inventors to try growing Bi films. Such work has been previously reported by Partin et al. in Physical Reviews B, 38, 3818-3824 (1988) and by Heremans et al. in Physical Reviews B, 38, 10280-10284 (1988). Success was obtained in growing epitaxial Bi thin films, with mobilities as high as 25,000 $cm^2V^{-1}sec^{-1}$ at 300°K (and 27,000 $cm^2V^{-1}sec^{-1}$ for $Bi_{1-x}Sb_x$ at 300°K). Magnetoresistors made from these films had very low sensitivities. Modelling studies which the inventors have just completed indicate that this is to their knowledge an unrecognized effect of the fact that the energy band structure of Bi has several degenerate conduction band minima. Other high-mobility materials shown in Table I have a single, non-degenerate conduction band minimum. InSb thin films (on semi-insulating GaAs substrates) were then grown using the metal organic chemical vapor deposition (MOCVD) growth techniques. After many months of effort, films with electron mobilities of only 5,000 $cm^2V^{-1}sec^{-1}$ were produced.

Growth of Indium Arsenide (InAs) on semi-insulating GaAs, and also on semi-insulating InP substrates, was tried. By "semi-insulating" is meant substrates of such high resistivity that they can be considered as substantially insulating. These latter substrates were made semi-insulating by doping them with Fe. They were tried in addition to GaAs because there is less lattice mismatch with InAs (see Table I). After some time, the inventors were able to produce InAs films with a room temperature mobility of 13,000 $cm^2V^{-1}sec^{-1}$ on InP substrates, and of lower mobility on GaAs substrates. The better InAs films were formed by the following process.

An MOCVD reactor manufactured by Emcore Corporation, U.S.A. was used. InP substrates were heated to the growth temperature in an atmosphere of 5333 Pa (40 torr) of high purity (palladium-diffused) hydrogen to which a moderate quantity of arsine was added (80 SCCM, or standard cubic centimetres per minute). This produced about 0.02 mole fraction of arsine. The arsine was used to retard thermal decomposition of the InP surface caused by loss of the more volatile phosphorus. The way in which arsine reduces the surface roughening during this process is not well understood. Phosphine would have been preferred, but was not available at the time in the reactor. After reaching a temperature of 600°C., the arsine flow was reduced to 7 SCCM, and ethyl-dimethyl indium (EDMIn) was introduced into the growth chamber by bubbling high purity hydrogen (100 SCCM) through EDMIn which was held at 40°C. Higher or lower arsine flows during growth gave lower mobilities and worse surface morphologies. After 2.5 hours of InAs growth time, the EDMIn flow to the growth chamber was stopped and the samples were cooled to room temperature in an arsine-rich atmosphere (as during heat-up).

The thickness of the resulting InAs film was 2.3 micrometres. From conventional Hall effect measurements at 300°K, the electron density was $1.4 \times 10^{16}$ cm$^{-3}$ and the electron mobility was 13,000 cm$^2$V$^{-1}$sec$^{-1}$. These are effectively averages since the electron density and mobility may vary within a film. The film was not intentionally doped. Even though this is a very disappointing mobility, a crude magnetoresistor was made, since this required very little effort. A rectangular sample was cleaved from the growth and In metal was hand soldered along two opposing edges of the sample, and leads were connected to the In metal. The length, which is the vertical dimension in Figures 1A and 1B, was 2 mm and the width, which was the horizontal dimension in Figures 1A and 1B, was 5 mm.

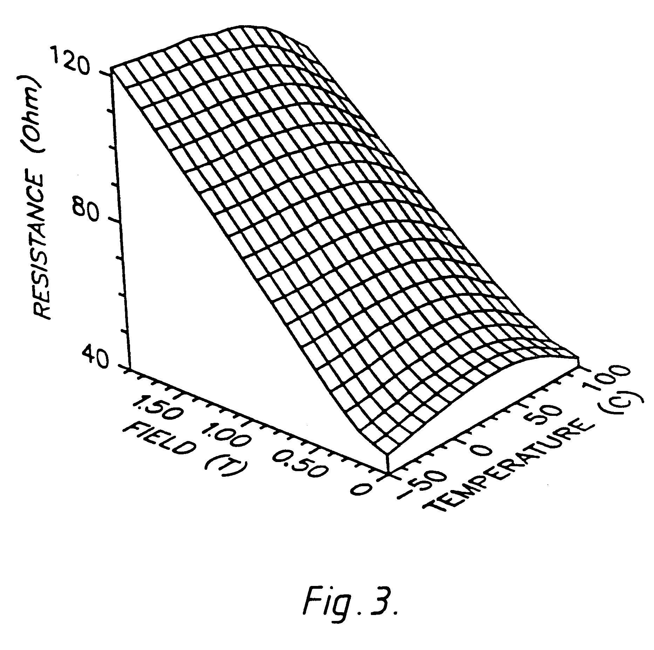

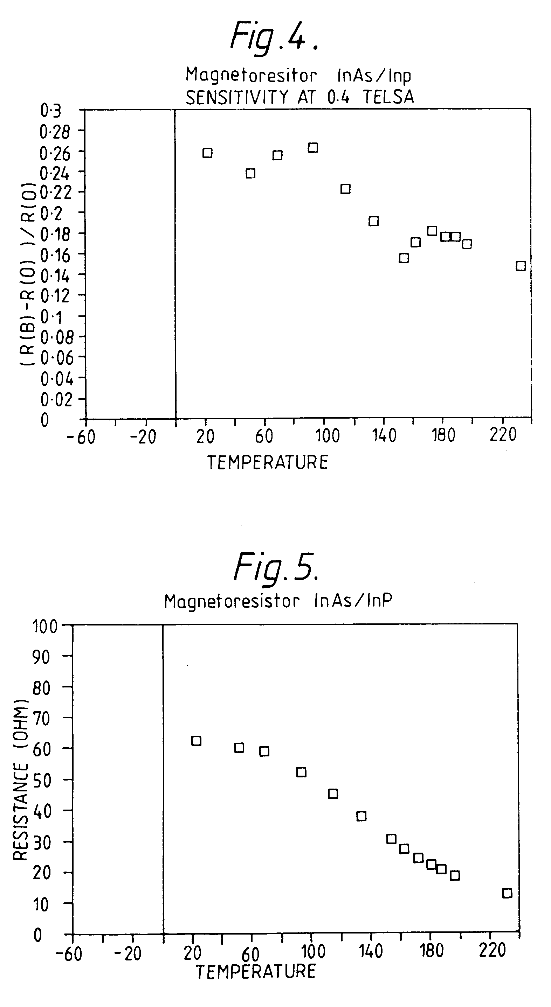

As expected, the resistance of the device was low (about 50 W) since the inventors did not have many elements in series. However, the magnetoresistance effect was large. It is shown in Figure 3. Furthermore, the device resistance and magnetoresistance were surprisingly stable with temperature in the range shown in Figure 3, which is -50°C. to +100°C. A second, similar device was tested less thoroughly at temperatures as high as +230°C. The results of this latter testing are shown in Figures 4 and 5. In Figure 4, the applied magnetic field was 0.4 Tesla. The fractional magnetoresistance is plotted as a function of temperature between B = 0.4 Tesla and B = 0. Despite the fact that the indium metal used for contacts has a melting point of 156°C., the magnetoresistor still functioned very surprisingly well at 230°C., with the fractional increase in resistance for a given magnetic field (0.4 Tesla) reduced by less than one half compared to the response near room temperature (as shown in Figure 4).

The device resistance in zero magnetic field, R(0), decreased over the same temperature range by a factor of 5 (as shown in Figure 5). The inventors also found this to be surprisingly good, even taking into account the relatively large energy gap of InAs.

The inventors own detailed analysis of transport data from these films suggests that there are current carriers with two different mobilities present. In retrospect, it looks like the results are related to an accumulation layer of electrons at the surface of the sensing layer. The inventors have now recognized that Wieder has reported in Appl. Phys. Letters, 25, 206 (1974) that such an accumulation layer exists just inside the InAs near the air/InAs interface. It appears to the inventors that there are some errors in the Wieder report. However, the inventors think that the basic conclusion that an electron accumulation layer exists is correct. These electrons are spatially separated from the positive charge at the air/InAs interface. Thus, they are scattered relatively little by this charge, resulting in a higher mobility than would normally be the case. They also exist in a very high density in such an accumulation layer, so that as the temperature increases, the density of thermally generated carriers is a relatively small fraction of the density in the accumulation layer. This helps stabilize the resistance (at zero magnetic field) with temperature. Thus, it appears that the relatively low measured electron mobility of 13,000 cm$^2$V$^{-1}$sec$^{-1}$ is an average for electrons in the accumulation layer and for those in the remainder of the thickness of the film.

Thus, normally one would want to grow a relatively thick layer of InAs to make a good magnetoresistor, since crystal quality (and mobility) generally improve with thickness when growing on a lattice-mismatched substrate. However, the thicker the layer becomes, the greater its conductivity becomes and the less apparent the benefits or presence of a surface accumulation layer would be. Thus, the inventors current understanding of their devices suggests that relatively thinner layers are preferable, even if the average film mobility decreases somewhat, since this will make the conductivity of the surface accumulation layer a greater fraction of the total film conductivity. The monocrystalline indium arsenide film in the position sensor of the present invention is approximately 1 - 3 micrometres thick, and has an average electron density of the order of $10^{16}$ electrons per cubic centimetre and an average electron mobility of about 10,000 - 15,000 cm $^2$V$^{-1}$second$^{-1}$. The exact relationships between film thickness, crystal quality and properties of the surface accumulation layer are currently under study.

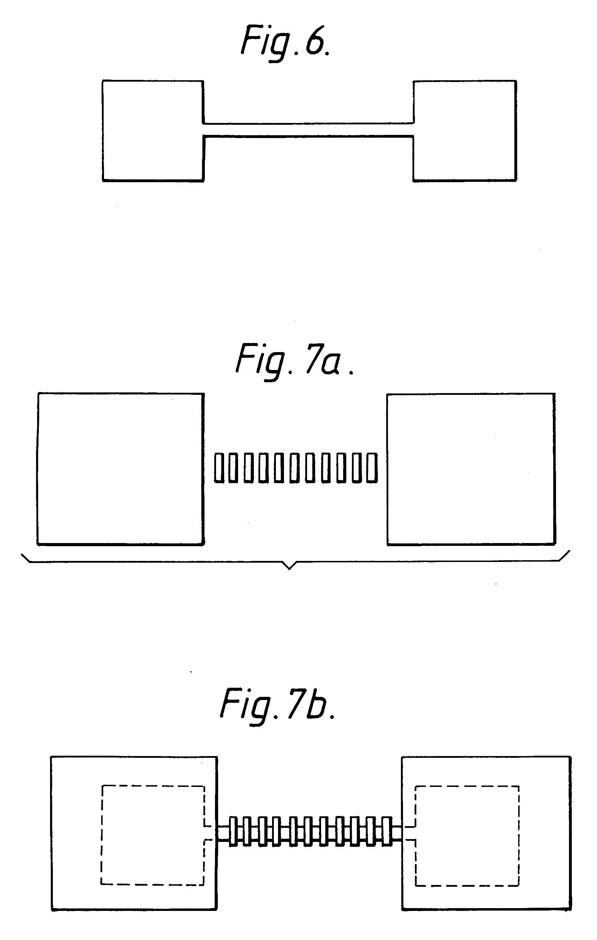

Multi-element magnetoresistors were subsequently made from this material using Au (or Sn) metallization. First, conventional photolithography techniques were used to etch away unwanted areas of an Indium Arsenide (InAs) film from the surface of the Indium Phosphide (InP) substrate to delineate the pattern shown in Figure 6. A dilute solution (0.5%) of bromine in methanol was used to etch the InAs. Then, a blanket layer of Au metallization 100 nanometres (1000 Angstroms) thick was deposited using conventional vacuum evaporation techniques over the entire surface of the sample, after removing the photoresist. Conventional photolithography was then used to etch away unwanted areas of the Au film to delineate the gold pattern shown in Figure 7A. A dilute aqueous solution of KCN was used for this step. (The inventors think dissolved oxygen is helpful, which can diffuse into the solution from ambient air or be supplied in the form of a very small addition of hydrogen peroxide.) The resultant composite of the two patterns, with the gold pattern overlying the InAs film pattern, is shown in Figure 7B.

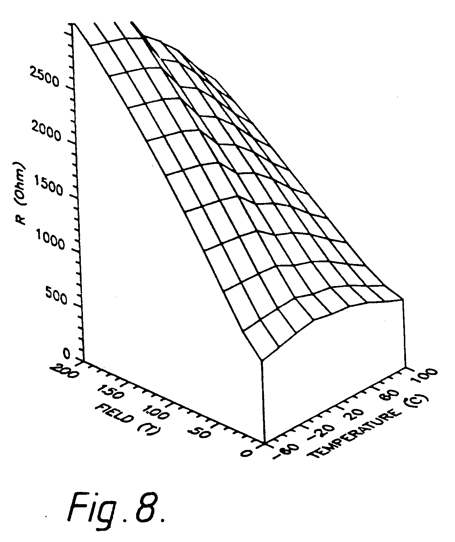

Leads were then attached by silver epoxy resin to the large Au end bonding pads. Leads could also be attached by normal and accepted filamentary wire-bonding techniques. If so, and especially if a modern wire-bonding apparatus were used, the bonding pads could easily be made much smaller. Also, many devices such as shown in Figures 6, 7A and 7B could be made simultaneously using conventional integrated circuit technology. The resulting devices typically have a resistance near 1 KW (typically + or - 20%) at room temperature in zero magnetic field. Surprisingly, the magnetoresistance effect on the multi-sensing area device was much larger than the effect on a single sensing area device. For comparison of these effects at a given magnetic field, see Figures 8 and 3. In the multi-element device (i.e., plural sensing area element), the sensing areas had a length to width ratio of 2/5. The inventors do not understand why the multi-element device works better since the length to width ratio of each element is 2/5, the same as for the single element device characterized in Figure 3, which was fabricated using part of the same InAs grown layer. Another multi-element magnetoresistor was made similarly to the one just described, but with a length to width ratio of 4/5. It had nearly as large a magnetoresistance as the one made according to the patterns in Figs. 4 and 5. Again, the inventors do not yet understand this, but the resulting devices work very well. Even a device with a length to width ratio of 6/5 works well.

The relative stability of these magnetoresistors with temperature also now appears to be increasingly important, since some automotive applications require operation from -50°C to as high as +170°C to +200°C, and there are known applications requiring even higher temperatures (to 300°C). There is reason to believe that the present invention will provide magnetoresistors operating at temperature as high as 300°C, and even higher.

A potential problem with InAs magnetoresistors made in accordance with this invention is the potential importance of the air/InAs interface, which might cause the device characteristics to be sensitive to changes in the composition of ambient air, or cause the characteristics to slowly change with time or thermal history because of continued oxidation of the surface. A preferred sensor according to this invention is one in which there is a protective but gas-permeable coating over each sensing area of the sensor. Preferably such a coating is permeable to ambient air. Coating the surfaces of two devices with a particular epoxy resin made by Emerson and Cuming, a division of Grace Co. U.S.A. has been tried. The epoxy resin used was "Stycast", number 1267. Parts A and B were mixed, applied to the devices, and cured at 70°C for two hours. The inventors did not observe any significant changes in the device characteristics at room temperature as a result of this encapsulation process. The inventors have not yet systematically tested these devices at other temperatures, but they are encouraged by this preliminary result. The inventors think other forms of encapsulants need to be explored, such as other epoxy resins and thin film dielectrics, such as $SiO_2$ or $Si_3N_4$.

In order to still have a very low metal-semi-conductor contact resistance between the InAs and the contact and shorting bar metallization, it may be necessary to modify the processing sequence previously described in connection with Figures 6, 7A and 7B. For example, with an inverse of the mask contemplated in the previous discussion, the photoresist on the surface could then be used as a mask for wet-etching (e.g., by wet chemicals or reactive ions, or ion beams) of the dielectric or high energy gap semi-conductor layer to expose the InAs. Au or other metals could then be deposited by vacuum evaporation (or by other conventional processes, such as sputtering, or electroplating) and then the photoresist could be removed, resulting in lift-off of the undesired regions of metal. Alternatively, after etching through to the InAs, the photoresist could be removed, Au or other metal could be deposited uniformly across the surface, and then, after deposition of photoresist, the mask pattern in Figure 7A could be aligned with the pattern etched into the dielectric and the Au could be patterned as before.

As an additional alternative, if a sufficiently thin layer (e.g., 20 nanometres (200 Angstroms)) of high energy gap semi-conductor is present, the original processing sequence described could be modified by deposition of a low-melting-temperature eutectic alloy, such as Au-Ge, Au-Ge-Ni, or Ag-Sn, in place of Au. After patterning similarly to the way the Au was patterned (or using the inverse of the mask in Figure 7A and lift-off), the sample is heated to a moderate temperature, typically to somewhere in the range of 360°C to 500°C for Au-Ge-based alloys, thus allowing the liquid metal to locally dissolve the thin layer of high-energy gap semi-conductor, effectively contacting the InAs.

In the most recent work, the InAs growth procedures are changed somewhat. The procedures are the same as before, but the InP wafer is heated to 460°C in a larger arsine mole fraction (0.1). After 0.5 minutes at 460°C, during which the native oxide on InP is believed to desorb, the temperature is lowered to 400°C and 20 nanometres (200 Angstroms) of InAs in thickness is grown. The temperature is then raised to the growth temperature of 625°C (with the arsine mole fraction still 0.1), and then EDMIn is introduced whilst the arsine flow is abruptly reduced to 5 SCCM (about 0.001 mole fraction). The EDMIn is kept at 50°C, and the high purity hydrogen is kept bubbling through it at a rate of 75 SCCM. Again, the arsine flow of 5 SCCM seems near-optimal for these growth conditions. The resulting films have somewhat enhanced sensitivity to a magnetic field relative to those grown earlier.

Whilst all of the recent work has concentrated on magnetoresistors fabricated from InAs films on semi-insulating (i.e., substantially electrically insulating) InP substrates, the inventors think that a more mature growth capability will permit films of InAs with nearly comparable quality to be grown on semi-insulating GaAs substrates as well. In either case, other growth techniques such as molecular beam epitaxy, liquid phase epitaxy or chloride-transport vapor phase epitaxy may also prove useful.

The above-mentioned Indium Arsenide (InAs) thin film devices, fabrication processes, and operating characteristics are described in and claimed in a separate European patent application based upon USSN 289,634.

On the other hand, the inventors think that the presence of what may be a naturally-occurring accumulation layer in the above-mentioned thin film InAs magnetoresistors is what makes them work so well, and which enabled production of a practical device. The inventors believe that this fundamental concept is new to magnetoresistors, and that this concept can be expanded in a multiplicity of ways, not only to Indium Arsenide but to other semi-conductive materials as well. In this patent application is further described and claimed a variety of techniques by which an accumulation layer can be induced in the semi-conductor layer, by other than a natural occurrence or inherent occurrence as a result of the fabrication process.

The following discussion describes some of the other ways of inducing or enhancing an electron accumulation or inversion layer in InAs thin films and in other semi-conductive materials in thin film form, to attain effective high mobilities. There are three basic advantages to the use of strong electron accumulation layers in magnetoresistor active regions. It is repeated here that the term "electron accumulation layer", as used in this patent application is also intended to include electron inversion layers.

First, electron accumulation layers or strong electron inversion layers can contain a density of electrons significantly larger than the intrinsic density at any given temperature. This must improve the temperature stability, since the thermally-excited carriers are a small fraction of the accumulated or strongly inverted ones.

Second, accumulation layers enhance the mobility of the carriers in the semi-conductor. This effect has been experimentally observed in thin indium arsenide (InAs) films, especially at higher temperatures. They will enhance the sensitivity of the magnetoresistor. One possible cause of this effect may be that in such accumulated or strongly inverted layers large electron densities can be achieved without the presence of a large density of ionized impurities in the same spatial region, which would limit the carrier mobility. This effect is similar to the "modulation doping" of layers described by G. Burns in Solid State Physics, pp. 726-747, Academic Press (1985). Such an effect is used in the fabrication of High-Electron-Mobility-Transistors (HEMTs).

Third, accumulation or strong inversion layers are inherently close to the surface or interface of a semi-conductor. This makes it relatively easy to induce, enhance, or control these accumulation or strong inversion layers through the use of thin film structures deposited on top of the semi-conductor, possibly in combination with voltage biases.

Accumulation layers have been used in silicon MOSFET Hall plates, and are described by H. P. Baltes et al. in Proc. IEEE, 74, pp. 1107-1132, especially pp. 1116-7, (1986). In the MOSFET Hall effect devices, a biased gate electrode in a Metal-Oxide-Semi-conductor was used to generate a suitably thin electron layer close to the Semi-conductor-Oxide interface. Four electrodes were then used to contact that layer: a source and a drain through which current is passed, and two intermediate electrodes across which the Hall voltage is generated. Further, Baltes et al. ibid. also describe a split-drain MOSFET using an accumulation-layer based sensor with only four electrodes (one source, two drains, and one gate). One of the virtues of a magnetoresistor over a Hall effect device is that the magnetoresistor has only two electrodes. In order to preserve this in the improved magnetoresistor concept of the present invention, the inventors propose to use, in conjunction with a magnetoresistor layout such as described in Figure 2, a number of new ways to generate accumulation or inversion layers without using externally-biased gate electrodes.

In a first embodiment, use is made of the fact that the natural interface between InAs and air is known to generate an electron accumulation layer in InAs. A similar effect may exist in InSb, and the technique may therefore be applicable to thin film magnetoresistors made with this semi-conductor material. The inventors would not, however, expect such devices to work as well as InAs at very high temperatures. The very small energy gap of InSb (see Table I) would cause thermal generation of carriers that would cause increased conductivity in the InSb film adjacent to the accumulation layer, making the conductivity of the accumulation layer a relatively small fraction of the total device conductivity. Thus, the benefits of the accumulation layer would be lost at a lower temperature in InSb than in the higher energy band gap InAs. The inventors experimentally grew a 2.3 thick epitaxial layer of InAs on an insulating InP substrate using Metal Organic Chemical Vapor Deposition (MOCVD). Hall and magnetoresistance measurements on the layer in the temperature range of 350°K to 0.5°K, and in magnetic fields up to 7 Tesla reveal the presence of at least two "types" of carriers, in roughly equal concentrations, but with very different mobilities (by a factor of 2 to 3). In retrospective view of the afore-mentioned Wieder publication, it is reasonable to assume that one of them is the accumulation layer located near the air interface. The inventors built two 2 mm long, 5 mm wide magnetoresistors out of this film which developed a very usable magnetic field sensitivity, whilst maintaining good temperature stability (see Figures 3, 4, and 5). The inventors believe it is possible to preserve this sensitivity after covering the InAs surface with a suitable encapsulating coating (e.g., an epoxy resin or other dielectric material).

In a second embodiment, a capping layer of a large-gap semi-conductor such as GaAs, InP, AlSb, or $In_{1-y}Al_yAs$ can be grown on top of the narrow-gap active layer semi-conductor (typically InAs or $In_{1-x}Ga_xAs$ with $0 < x < 0.5$, although a similar structure using InSb can be conceived). In this capping layer the inventors put donor-type impurities, such as Si, Te, Se, or S. These will release an electron, which will end up in the layer where it has minimum energy, i.e., the narrow-gap semi-conductor. This leaves a layer of positively ionized donor-impurities in the large-gap capping layer; but they are spatially removed from the electrons in the active layer, and hence do not significantly scatter them.

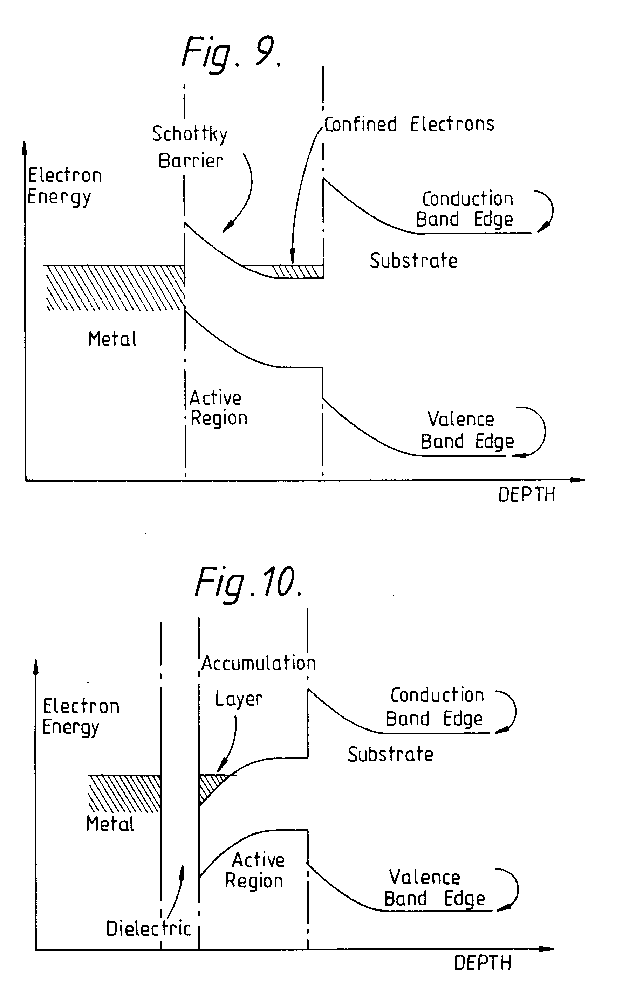

In a third embodiment, the inventors propose to deposit a layer of metal on top of the device active region with the purpose of creating a Schottky barrier. A plot of the electron energy levels adjacent the metal-semi-conductor interface in this third embodiment is shown in Figure 9. In referring to Figure 9, it can be seen that there will be a depletion of the top region of the active narrow-gap semi-conductor. If the active layer is thin enough (100-200 nanometres (1000-2000 Angstroms)), this will confine electrons in the active layer towards the substrate, resulting in electrical properties similar to those of an accumulation layer. Metals that generally form Schottky barriers to III-V compounds, such as Au or Al may be useful, although the inventors have not adequately studied this structure experimentally yet.

In a fourth embodiment, the inventors propose to deposit on the active layer of a narrow-gap semi-conductor a layer of large-gap semi-conductor, or of a dielectric such as $SiO_2$ or $Si_3N_4$, and on top of that a gate electrode. An electron energy plot going through the layers at the relevant interfaces is shown in Figure 10. The metal of the gate electrode in Figure 10 can be chosen such as that it induces an accumulation region near the semi-conductor-dielectric interface, by effect of the difference between the electron affinity in the semi-conductor, and the work function in the metal. Conversely, a different metal with larger work function can be used to deplete the semi-conductor-dielectric interface and electrostatically confine the electrons near the substrate, much as in the third embodiment mentioned above.

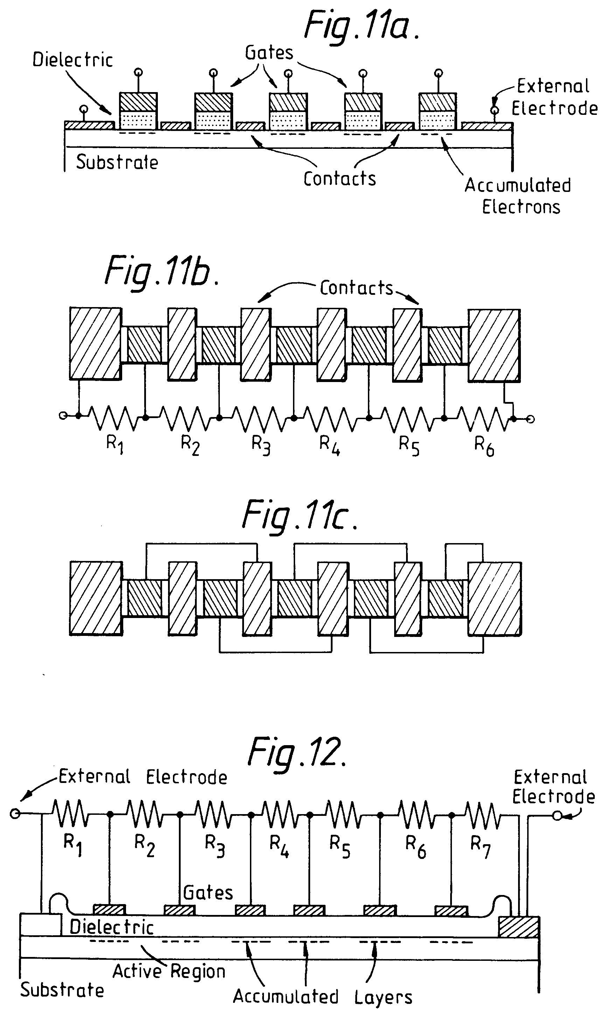

In a fifth embodiment, it is suggested that the gate electrodes described in the fourth embodiment be biased so as to generate accumulation layers in the semi-conductor under them. Such a concept is schematically shown in Figures 11A, 11B, and 11C. In Figure 11A, it can be seen that, if desired, one could use one or more added contacts to separately bias the gate electrodes. This would not ordinarily be preferred but could be done. It would not be preferred because one of the advantages to a magnetoresistor resides in that it only has two contacts. It is only shown here for completeness. On the other hand, additional contacts are not actually necessary. The gate electrodes can be electrically biased by an internal resistor circuit, examples of which are shown in Figures 11B and 11C.

Reference is now specifically made to the fifth type of embodiments shown in Figures 11b and 11C. Since the gate leakage currents are very minimal, a very high resistance ( >1MW) circuit can be used for biasing. As a special case in Figure 11B, resistor R1 can be made extremely large (open-circuit), and the other resistors can all be made to have zero resistance (short-circuit). Thus, the full positive bias applied to one external electrode (relative to the other external electrode) is applied to all gates in this special case. An alternative is to connect the gates over each semi-conductor region with the shorting bar between two other semi-conductor regions located such that the potential difference between the gate (i.e., the shorting bar) and the active region induces an accumulation layer in the latter. This latter version of internal biasing of the gate electrodes is shown in Figure 11C. A special case of this configuration is one in which each gate is connected to the adjacent shorting bar. In this configuration, each element might be considered to be a MISFET transistor with gate and drain shorted.

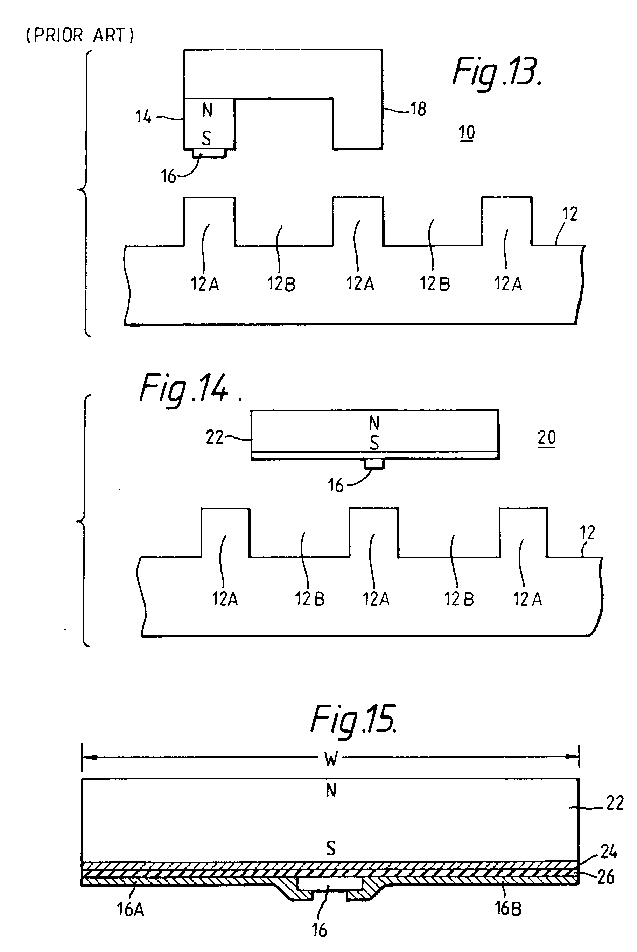

In the five preceding embodiments, the accumulation layers were used only to enhance the desirable transport properties of the semi-conductor in the sensing area. The configuration of the magnetoresistor, i.e., the length over width ratio of each active element, was still defined by the use of metallic shorting bars. The structure of Figure 11B can be extended to define the configuration of the magnetoresistive elements themselves, by modulating the carrier density and hence the conductivity, inside the semi-conductor active layer. This forms a sixth embodiment of this invention. An example of such a structure is schematically shown in Figure 12. Again, an external (integrated into the chip) resistance network is used in this sixth embodiment to bias a succession of gate electrodes to create a series of strongly accumulated regions.

These can be used instead of metallic shorting bars to create geometrical magnetoresistance. Such a structure could potentially be superior to one in which metallic shorting bars are used, because field-insensitive contact resistances between the metal and the semi-conductor would be eliminated.

Again, a special case can be considered for this sixth embodiment, as was considered in the fifth embodiment. In this special case of the sixth embodiment, the resistor R1 of Figure 12 is open-circuited and the other resistors (R2, R3 ...) are short-circuited, so that the entire positive bias applied to one external electrode is also applied to each gate. Thus, the natural accumulation layer normally present on an InAs surface would exist between the gates as in Figure 11A, but have a lower electron density. If desired, the gates could be biased negatively to eliminate the electron accumulation layers between the gates, or even to generate a strong inversion layer with carriers of the opposite type (holes). While the emphasis of this record of invention is on devices with only two external leads, the gates could be connected through a resistor network to a third external lead, making this version of the magnetic field sensor externally controllable through a voltage bias externally supplied to the gate lead. As hereinbefore indicated, a similar three terminal device could be made with the device shown in Figure 11A.

In a seventh embodiment, a lightly p-type film is grown (typically doped with Zn, Cd, Mg, Be, or C). In the case of InAs, the surface would, the inventors believe, still have a strongly degenerate electron layer, but it would be an inversion layer. Such an inversion layer would have a large electron density near the surface, and then a relatively thick (typically 0.1 mm to 1 mm or more, depending on dopant density) region of very low carrier density, similar to the space charge region of an $n+/p$ junction. This might be advantageously used to reduce the conductivity of the film adjacent to the electron-strong inversion layer. At very high device operating temperatures, the intrinsic carrier density of narrow energy gap semi-conductors like InAs would tend to defeat this strategy somewhat, and other, higher energy gap semi-conductors such as $In_{1-x}Ga_xAs$ might be preferred (see Table I). $In_{0.53}Ga_{0.47}As$ is a special case, since it can be lattice-matched to semi-insulating InP substrates. This makes it easier to grow such films with high crystalline quality.

The acceptor dopants mentioned above (i,.e., Zn, Cd, Mg, Be, and C) have small activation energies in the III-V compounds of interest (see Table 1). However, there are other acceptor dopants with relatively large activation energies, such Fe, in $In_{0.53}Ga_{0.47}As$. This means that relatively large thermal energy is required to make the iron ionize and contribute a hole to conduction. However, the iron will compensate for a concentration of donor impurities frequently present in the material, so that they do not contribute electrons to the conduction band. Thus, doping this material with iron will make it tend to have a high resistivity, except in the electron-rich accumulation layer. It would in this case be desirable to grow a thin undoped $In_{0.53}Ga_{0.47}As$ layer (e.g., 0.1 micrometre thick, after correcting for iron diffusion effects) on top of the iron-doped layer in order to obtain the highest possible electron mobility and density in the accumulation layer. It is recognized however, that finding suitable dopants with large activation energies may not be practical for smaller band gap semi-conductive materials. Furthermore, the other embodiments discussed above could also be used in conjunction with this one advantageously to reduce the conductivity of the film adjacent to the high electron density region.

The emphasis of the above discussion has been on electron accumulation or inversion layers. Hole accumulation or inversion layers could also be used. However, electrons are usually preferred as current carriers in magnetoresistors since they have higher mobilities in the materials shown in Table I.

With reference now to the drawings, Figure 13 shows a typical prior-art form of position sensor 10 in which the magnetic circuit comprises an exciter portion 12 of ferromagnetic material made up of a succession of teeth 12A spaced by gaps 12B and a stationary sensing portion comprising a permanent magnet 14 supporting on one surface a sensing element 16 and a flux guide 18 for providing a return path for the magnetic field. As shown, the width of each tooth is about equal to the width of the magnet and of the sensing element. Optionally, a field concentrator (not shown) may be localized over the sensing element 16 in the form of a thin layer of a high-permeability ferromagnetic material.

The exciter 12 typically is a plate with spaced teeth along one edge and is adapted to move horizontally so that its teeth pass under the permanent magnet 14 and the sensing element 16 in accordance with the movement of a position that is being sensed. Alternatively, the exciter may be a circular plate, with teeth around its circumference interspersed with slots, that rotates about a fixed centre for varying the position of the teeth relative to the sensing element. The exciter is typically of a high-permeability ferromagnetic material, such as iron.

The permanent magnet is polarized vertically in the plane of the paper, as indicated. The sensing element typically is a magnetoresistor, a two terminal element whose resistance increases with increasing magnetic flux passing vertically through its bulk and typically had nearly the same width as the magnet. The sensing element 16 is as hereinbefore described.

The flux guide 18 also is advantageously of a high-permeability material, such as iron, and its presence can increase the flux density through the sensor by providing an efficient return path for the flux passing through the exciter. To this end, the centre-to-centre spacing of adjacent teeth of the exciter and the centre-to-centre spacing of the magnetic path formed by the permanent magnet and the flux guide are made essentially equal, as shown. Such a flux guide, however, in fact adds little to the sensitivity and so is unnecessary if adequate flux density is provided, either by a magnet of sufficient thickness or choice of magnet material.

Typical dimensions might be about one millimetre both for the vertical thickness and for the horizontal width of the magnet 12, similarly about one millimetre for the height and width of each tooth 12A, about two millimetres for the width of a gap 12B, and about one millimetre for the separation between a tooth and the magnet in the position shown. The flux guide 18 typically would be of the same scale and would add about another millimetre to the height of the magnet path. The lateral dimension of the magnet normal to the plane of the drawing typically is wide enough to keep low any edge effects in the sensing element.

With a magnetic circuit of this kind, the maximum sensitivity that is obtained tends to be less than about five percent. Moreover, sensors are known in which the stationary part of the magnetic circuit includes a pair of magnetic sensing elements for use as separate legs of a differential sensor. In such cases, the two sensing elements typically are so spaced that when one of the sensing elements is positioned directly opposite one tooth, the other sensing element is positioned directly opposite the centre of the gap between adjacent teeth to maximize the difference of the outputs from the time sensing element. Such sensors provide higher sensitivities but at the expense of greater complexity.

In Figure 14, there is shown a position sensor 20 in accordance with a preferred embodiment of the present invention. Its magnetic circuit includes the exciter 12 that may be similar to the exciter included in the position sensor 10 shown in Figure 13 and so the same reference number is used. The stationary portion of the magnetic circuit is shown in greater detail in Figure 15. It includes a permanent magnet 22, magnetized vertically as shown, and on its bottom surface there is provided sensing element 16 that may be similar to sensing element 16 in the position sensor 10 of Figure 13. In accordance with a feature of the invention, intermediate between the sensing element 16 and the permanent magnet 22 there is included a layer 24 of high-permeability magnetic material, such as iron, that covers the entire bottom surface of the permanent magnet 22. Additionally, to ensure that this layer does not electrically short the sensing element 16, there is included an insulating layer 26 intermediate between the sensing element 16 and the layer 24. If the layer 24 were of a non-conducting material, such as high-permeability ferrite, the insulating layer 26 would become unnecessary and so might be omitted.

In sensor 20, in accordance with a feature of the invention, for increased sensitivity the width W of the permanent magnet 22 is considerably wider than the typical width of the prior-art sensor 10 shown in Figure 13. Advantageously, the width of the permanent magnet is made to be the sum of the width of one tooth and two gaps of the exciter, as shown, as seen in Figure 14, and so about one and one half times the pitch of the teeth of the exciter. By way of contrast, in the sensor shown in Figure 13, the width of the permanent magnet 14 essentially matches that of a tooth 12A of the exciter. Moreover, the improvement in sensitivity provided by this increase in magnet width is further augmented by the presence of the magnetic layer 18.

For maximum magnetic sensitivity, in the present design it is another feature that the width of the sensing element is desirably as narrow as is convenient. However, for electrical circuit efficiency, it is desirable that the element have a sufficiently high resistance, for example, at least 100 ohms, which imposes practical limits on how narrow the element may be. Also the sensing element needs to be wide enough to have adequate power dissipation capabilities. Nevertheless, the sensing element typically would be significantly narrower than the tooth element unless the exciter design involved unusually narrow teeth. As shown, the sensing element 16 is provided at opposite ends with electrodes 16A and 16B by means of which it may be connected into an appropriate electrical circuit. These are typically metallic platings deposited on the insulating layer 26. The ferromagnetic layer illustratively can be about 0.1 millimetres thick and of a material such as low-carbon steel 1008. The result is a configuration made up of a series of planar layers that is easy to manufacture.

The sensing element 16 typically is chosen in accordance with the particular application intended. A magnetoresistor is preferred, for reason apparent from the foregoing. It is preferable that the magnetic field be applied perpendicularly to the major face of the sensing area in the sensing element.

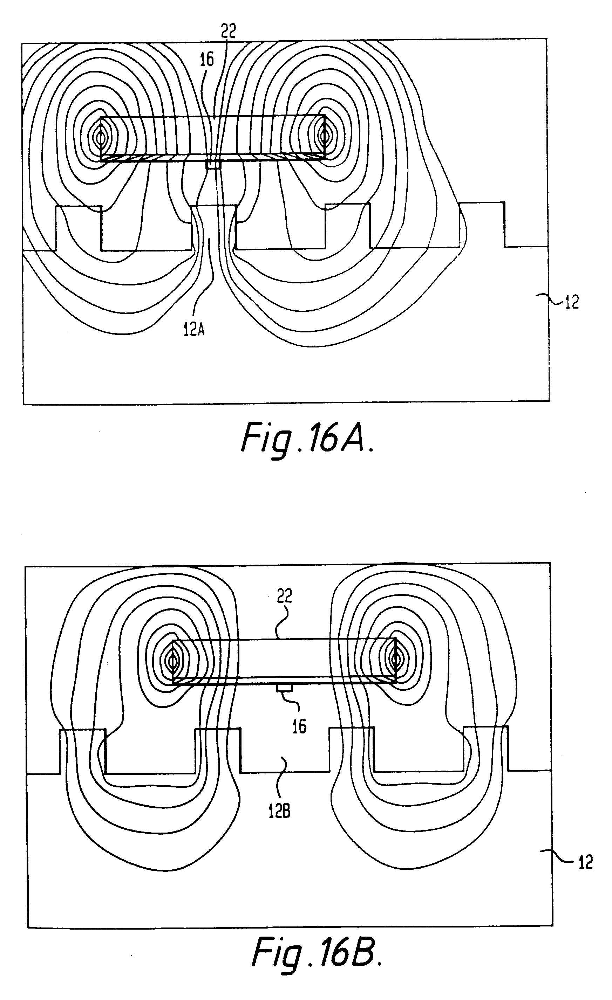

Figures 16A and 16B illustrate the conditions for maximum and minimum flux through the sensing element 16 respectively for the position sensor 20 shown in Figure 14. As seen in Figure 16A, when the sensing element 16 is directly opposite a tooth 12A of the exciter, the flux density represented by lines 30 through sensing element 16 is comparatively high. However, when the exciter has moved so that the sensing element 16 is opposite the centre of a gap 12B between teeth, the flux density through the sensing

EP 0 357 199 B1

element 16 is comparatively less. Typically, the maximum flux density may be 0.2 Tesla and the minimum flux 0.15 Tesla for a 2 millimetre thick MQ2 magnet. MQ2 magnet material is an NdFeB alloy that has an energy product between 13 -15 MGOe, is isotropic and 100 percent dense and is a trademarked product of General Motors Corporation.

The role of the ferromagnetic layer 24 makes it easier for the flux to travel towards or away from the sensing element 16, thus increasing the maximum flux and decreasing the minimum flux that passes through the sensing element, and thereby increasing the sensitivity, which is dependent on the difference between the maximum and minimum fluxes sensed.

In particular, the movement of the exciter teeth little affects the total flux density but does vary the spatial distribution of the flux density along the width of the magnet, creating sharp local flux density variations that can be sensed by a localized sensing element, such as a magnetoresistor. The ferromagnetic layer permits the flux density to be distributed along the magnet width in a way that reflects the profile of the air gap between the stationary portion of the magnetic circuit and the exciter. Where this air gap is narrow, the flux density is high, where this gap is wide, the flux density is low. Since this air "gap" is narrowest alongside a tooth of the exciter, the flux density there will be highest and this density peak will follow the tooth movement along the width of the magnet. In particular, tests have shown that the addition of the thin ferromagnetic layer 24 in the manner described can essentially double the sensitivity of a sensor with an already optimum width magnet. The optimum thickness of the ferromagnetic layer is determined by the maximum flux density it is desired to guide without saturation. Layers even as thin as five micrometres have proved to be useful for a sensed maximum flux density of about 0.12T. For this flux density, improvement tends to level off when the thickness reaches about 25 micrometres.

The magnetic layer 24 can be provided simply as a thin metallic foil attached to the surface of the permanent magnet 22 using conventional adhesives. Alternatively, magnets manufactured by compressing and/or sintering magnetic powder, such as MQ2 previously described, can produce a ferromagnetic layer as an integral part of the permanent magnet. To this end there is introduced into the die cavity an appropriate amount of iron powder, before or after the magnetic powder is introduced, and then the powders are compressed together. Moreover, the planar configuration of the devices makes feasible batch-processing whereby hundreds of magnetoresistors may be deposited simultaneously on a relatively thin unmagnetized permanent magnet wafer having a ferromagnetic layer and an insulating layer. The wafer would then be cut into separate sensors, the sensors packaged, and the permanent magnets magnetized.

It appears that the increase in sensitivity is achieved at the expense of a lowering of the mean flux density. If this is of concern for effective modulation of the particular magnetoresistor being used, the mean flux density can be increased to the desired level with little effect on the sensitivity by increasing the thickness of the magnet and/or the magnet type, thereby maintaining the desired planarity of the sensor and avoiding the need for a flux guide to improve flux density. However, in special instances where neither of these expedients is adequate, a flux guide may be induced to improve the flux density involving teeth further along the exciter.

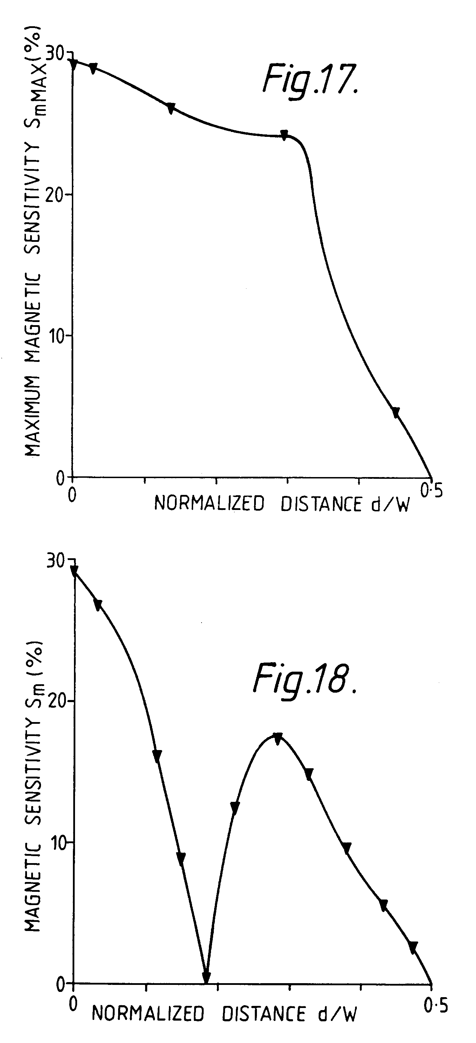

In order to translate optimally the high magnetic sensitivity of the magnetic circuit described into high electrical sensitivity, the sensing element needs to be appropriately positioned on the magnet. Figure 17 shows a typical envelope of maximum attainable sensitivity plotted against the normalized distance d/W of the sensing element where d is the distance from the midpoint of the magnet of width W. It can be seen that the peak attainable sensitivity is at the midpoint of the magnet (d = 0) and at a minimum at each end of the magnet (d/W = 0.5). Accordingly, the optimum location of the sensing element is at the midpoint of the magnet.

It is also important to have a proper width for the sensing element, particularly when the element is a magnetoresistor that produces an electrical output signal corresponding to the average of the flux density across its surface.

The flux density distribution along the length of the magnetoresistor, however, can be assumed to be constant. Thus, one is required to consider the flux density or sensitivity distributions only along the magnetoresistor width. Because of that, the effective electrical sensitivity will be directly related to the average magnetic sensitivity as determined by integrating the magnetic sensitivity distribution given in Figure 18 over the magnetoresistor width WMR. Figure 18 shows how the sensitivity varies along the magnet width for the alignment shown in Figures 16A and 16B. Looking at the sensitivity distribution, one would tend to maximize the electrical sensitivity by attempting to make WMR as small as possible. Small size, however, would lower the resistance and power dissipation capability of the magnetoresistor, and in turn lead to a lower output signal. The selection of WMR has to be a compromise which takes into account several conflicting requirements such as the practical limitations on the magnetoresistor length, the best possible sensitivity, sufficiently large resistance and power dissipation, and the lowest possible magnetoresistor cost (smaller magnetoresistors are generally less expensive). Considering previously available magnetoresistor technology, the minimum practical value of WMR for the exciter design that has been discussed appears to be about 0.3mm which amounts to d/W = 0.033 and yields an effective magnetic sensitivity SM of about 28 percent. The inventors do not know at this time how this is affected by the improved magnetoresistor contemplated in this invention. A 0.6mm width would still provide sensitivity of about 26 percent. The width WMR in any case desirably should be less than the width of the teeth in the usual design. The height of the sensing element may be small, typically tens of micrometres, whereby the planarity of the associated surface is little disturbed by its presence.

It is also found in the present design that the ratio of tooth width T to tooth pitch P also affects sensitivity. It has been found that the sensitivity tends to be maximum for T/P ratios of about 0.25 but to remain relatively flat over the range between 0.17 and 0.37.

It is also found in the present design that the tooth pitch affects sensitivity and in particular that increasing the tooth pitch can appreciably increase the sensitivity. For example, for the design discussed, a change in pitch from 3mm to 5mm can increase the maximum sensitivity to about 58 percent when conditions are optimized. Since sensitivity decreases with increasing air gap size between the exciter and the magnet, increasing the tooth pitch offers a way to compensate for larger air gap sizes and offers a designer an ability to trade off between air gap width and tooth pitch.

In addition, it is found that the stationary portion of a sensor of the kind described can be used effectively with a broad range of exciter wheel tooth pitch sizes. This feature offers a considerable cost saving potential, for example, for applications such as ABS designs that employ widely differing tooth pitch sizes. If a sensor of a particular stationary design is intended to operate with wheels having different tooth pitch sizes, the magnet width preferably should be chosen to optimize the sensor for the smallest tooth pitch size so that the lowest sensitivity, encountered when using the exciter wheel of smallest tooth pitch size, will be as high as possible. As previously discussed, the optimum magnet width is about 1.5 times the tooth pitch size.

It is to be understood that the specific embodiments described are merely illustrative of the general principles of the invention and various modifications may be devised within the scope of the invention as claimed. For example, it is feasible to reverse the roles of the stationary portion and the movable portion of the position sensor. Additionally, the various dimensions and materials mentioned are merely illustrative of a typical design and other designs could necessitate other dimensions and materials.

**Claims**

1. A position sensor (20) that includes a magnetic circuit having an exciter portion (12) including teeth (12A) spaced apart by gaps (12B) and a sensing portion for sensing relative movement of the exciter portion with respect to the sensing portion, wherein the sensing portion includes a permanent magnet (22) having one surface approximate the exciter portion (12) and being relatively wide compared to the width of an exciter tooth (12A), and a magnetic sensing element (16) on said magnet (22), characterised in that there is a layer of high-permeability magnetic material (24) covering entirely said one surface, said magnetic sensing element (16) is positioned on said layer (24) along a limited portion intermediate between the two ends of the permanent magnet (22), the magnetic sensing element (16) includes a thin film of a monocrystalline semi-conductive material approximately 1-3 micrometres thick, supported on a substantially electrically-insulating substrate, said thin film having only a moderate average current carrier density of the order of $10^{16}$ electrons per cubic centimetre, a moderate average current carrier mobility of at least 10,000 $cm^2$ $volt^{-1}$ $second^{-1}$, and a band gap of at least 0.35 electron volts; a sensing area in said thin film; and an accumulation layer in said thin film extending across said sensing area and disposed adjacent a surface of said thin film, where said current carriers can preferentially flow between conductive portions contacting opposed edges of said sensing area.

2. A position sensor (20) according to claim 1, characterised in that said position sensor provides unamplified electrical output changes of the order of one volt in response to changes in applied magnetic field over a temperature range of several hundred degrees Centigrade; said permanent magnet (22) has a width (W) which is at least several times wider than the width of an exciter tooth (12A) said thin film included in the magnet sensing element (16) is a thin film of monocrystalline indium arsenide (16) having inner and outer surfaces, with the inner surface being supported on a substantially electrically-insulating monocrystalline indium phosphide substrate; the sensing area in said indium arsenide film (16) is a substantially rectangular sensing area having an electrical conductor extending along the length of each long edge of the rectangular sensing area; each of said exciter teeth (12A) has a width that is greater than the dimensions of said sensing area; and said thin film of indium arsenide (16) is nominally undoped, and has an average electron mobility of about 10,000 - 15,000 cm$^2$ volt$^{-1}$ second$^{-1}$ but which exhibits a magnetic sensitivity and temperature insensitivity as if the indium arsenide film (16) were at least an order of magnitude thinner, had an electron density at least an order of magnitude greater, and a significantly higher mobility.

3.  A position sensor (20) according to claim 2, <u>characterised in that</u> the substantially rectangular sensing area also has a dimension along its short edges that is about 30% -50% that of its long edges.

4.  A position sensor (20) according to claim 2 or 3, <u>characterised in that</u> the accumulation layer is an electron accumulation layer adjacent the outer surface of said indium arsenide thin film (16) which extends entirely across the sensing area between the conductors contacting its long edges, which accumulation layer has an electron density at least an order of magnitude higher than said average electron density and an electron mobility significantly greater than said average electron mobility, effective to provide said magnetic sensitivity and said range of operating temperature.

5.  A position sensor according to claim 1, <u>characterised in that</u> the semi-conductive material of the thin film is indium arsenide, and the magnetic sensing element (16) includes an air-permeable coating on the indium arsenide thin film for maintaining said accumulation layer in said film during use of the position sensor without requiring more than two electrical contacts to said sensing element (16).

6.  A position sensor according to claim 5, <u>characterised in that</u> the width (W) of said magnet (22) is approximately one and one half times the tooth pitch of the exciter portion (12), the magnetoresistive sensing element (16) includes a plurality of said thin film sensing areas, said sensing areas are connected electrically in series with one another, and said sensing areas are disposed in a combined area having a maximum dimension less than the width of said exciter tooth (12A).

7.  A position sensor according to claim 6, <u>characterised in that</u> the coating includes a conductive electrode layer for inducing an electric field in the thin film to create the accumulation layer, and the means for maintaining the accumulation layer further includes electrical biasing means interconnecting the conductive electrode layer with said conductive portions contacting opposed edges of said sensing area.

8.  A position sensor according to claim 6, <u>characterised in that</u> the ratio of the tooth width to the tooth pitch is between about 0.17 and 0.37.

9.  A position sensor according to claim 1, <u>characterised in that</u> the layer of high-permeability magnetic material is a ferromagnetic layer (24) overlying said one surface; the magnetic sensing element (16) is centred along the width of said surface over said layer (24), the width of said magnetic sensing element (16) being substantially less than the width (W) of said magnet (22); the width of each of said teeth (12A) is less than the width of each of said gaps (12B) and more than the width of said sensing element (16); said thin film is formed of monocrystalline indium arsenide and has a generally rectangular sensing area; there are substantially parallel conductors contacting said thin film for injecting current carriers into opposed edges of said sensing area; said sensing area has a dimension in a direct path between said conductors that is significantly shorter than its dimension parallel to said conductors, and said sensing area dimensions are less than the width of said exciter tooth (12A).

10. A position sensor according to claim 9, <u>characterised in that</u> said sensing element (16) has a plurality of sensing areas, the sensing areas are successively disposed in an elongated portion of the thin film, with each sensing area extending across the entire width of the elongated portion, a conductor extends across the entire width of the elongated portion on opposite sides of each sensing area, and the length of the elongated portion of the film has a dimension less than the width of said exciter tooth (12A).

**Patentansprüche**

1.  Ein Positionssensor (20), der einen magnetischen Kreis mit einem Erregerteil (12), das Zähne (12A) umfaßt, die durch Lücken (12B) voneinander beabstandet sind, und einen Erfassungsteil für das Erfassen der relativen Bewegung des Erregerteils mit Bezug auf das Erfassungsteil umfaßt, worin das

15

Erfassungsteil einen Permanentmagneten (22), der eine Oberfläche dicht an dem Erregerteil (12) hat und relativ breit verglichen mit der Breite eines Erregerzahns (12A) ist, und ein magnetisches Erfassungselement (16) auf dem Magneten (22) umfaßt,

dadurch gekennzeichnet, daß es eine Schicht von magnetischem Material hoher Permeabilität (24) gibt, die die eine Oberfläche vollständig abdeckt, das magnetische Erfassungselement (16) auf der Schicht (24) längs eines begrenzten Teils zwischen den zwei Enden des Permanentmagneten (22) angeordnet ist, das magnetische Erfassungselement (16) einen dünnen Film eines monokristallinen halbleitenden Materials näherungsweise 1 bis 3 $\mu$m dick umfaßt, das auf einem im wesentlichen elektrisch isolierenden Substrat getragen wird, wobei der dünne Film nur eine moderate Durchschnittsstromträgerdichte der Größenordnung von $10^{16}$ Elektronen pro Kubikzentimeter hat, eine moderate Durchschnittsstromträgermobilität von zumindest 10.000 cm$^2$Volt$^{-1}$Sekunde$^{-1}$ und eine Bandlücke von zumindest 0,35 Elektronenvolt; einen Erfassungsbereich in dem dünnen Film; und eine Anreicherungsschicht in dem dünnen Film, die sich über den Erfassungsbereich erstreckt und benachbart einer Oberfläche des dünnen Films angeordnet ist, wo die Stromträger bevorzugterweise zwischen leitfähigen Teilen fließen, die gegenüberliegende Ränder des Erfassungsbereiches kontaktieren.

2. Ein Positionssensor (20) nach Anspruch 1, dadurch gekennzeichnet, daß der Positionssensor unverstärkte elektrische Ausgangsänderungen der Größenordnung von einem Volt in Abhängigkeit von Änderungen im angelegten Magnetfeld über einen Temperaturbereich von mehreren hundert Grad Celsius vorsieht; der Permanentmagnet (22) eine Breite (W) hat, welche zumindest mehrere Mal breiter als die Breite eines Erregerzahns (12A) ist, der dünne Film, der in dem Magneterfassungselement (16) beinhaltet ist, ein dünner Film von monokristallinem Indiumarsenid (16) mit inneren und äußeren Oberflächen ist, wobei die innere Oberfläche auf einem im wesentlichen elektrisch isolierenden monokristallinen Indiumphosphidsubstrat getragen wird; der Erfassungsbereich in dem Indiumarsenidfilm (16) ein im wesentlichen rechteckiger Erfassungsbereich mit einem elektrischen Leiter ist, der sich längs der Länge von jeder langen Kante des rechteckigen Erfassungsbereiches erstreckt; jeder der Erregerzähne (12A) eine Breite hat, die größer als die Abmessungen des Erfassungsbereiches ist; und der dünne Film von Indiumarsenid (16) nominell undotiert ist und eine Durchschnittselektronenmobilität von ungefähr 10.000 bis 15.000 cm$^2$Volt$^{-1}$Sekunde$^{-1}$ hat, aber welcher eine magnetische Empfindlichkeit und Temperaturunempfindlichkeit zeigt, als wenn der Indiumarsenidfilm (16) zumindest eine Größenordnung dünner wäre, eine Elektronendichte von zumindet einer Größenordnung größer und eine signifikant höhere Mobilität hätte.

3. Ein Positionssensor (20) nach Anspruch 2, dadurch gekennzeichnet, daß der im wesentlichen rechteckige Erfassungsbereich auch eine Abmessung längs seiner kurzen Kanten hat, die ungefähr 30 % - 50 % jener von ihren langen Kanten ist.

4. Ein Positionssensor (20) nach Anspruch 2 oder 3, dadurch gekennzeichnet, daß die Anreicherungsschicht eine Elektronenanreicherungsschicht benachbart der äußeren Oberfläche des dünnen Indiumarsenid-Films 16 ist, welche sich vollständig über den Erfassungsbereich zwischen den Leitern erstreckt, die seine langen Ränder kontaktieren, welche Akkumulationsschicht eine Elektronendichte von zumindest einer Größenordnung höher als die durchschnittliche Elektronendichte und eine Elektronenmobilität signifikant größer als die Durchschnittselektronenmobilität hat, die wirksam ist, um die magnetische Empfindlichkeit und den Betriebstemperaturbereich zu schaffen.

5. Ein Positionssensor nach Anspruch 1, dadurch gekennzeichnet, daß das Halbleitermaterial des dünnen Indiumarsenid-Film ist und das magnetische Erfassungselement (16) einen luftpermeablen Überzug auf dem Indiumarsenid dünnen Films zum Aufrechterhalten der Anreicherungsschicht in dem Film während der Verwendung des Positionssensors umfaßt, ohne mehr als zwei elektrische Kontakte an dem Erfassungselement (16) zu erfordern.

6. Ein Positionssensor nach Anspruch 5, dadurch gekennzeichnet, daß die Breite (W) des Magneten (22) näherungsweise 1 1/2 mal der Zahnabstand des Erregerteils (12) ist, das Erfassungsmagnetoresistoranordnungselement (16) eine Vielzahl von Erfassungsbereichen aus dünnem Film umfaßt, die Erfassungsbereiche elektrisch in Reihe miteinander geschaltet sind und die Erfassungsbereiche in einem kombinierten Bereich mit einer maximalen Abmessung weniger als die Breite des Erregerzahns (12A) angeordnet sind.

**7.** Ein Positionssensor nach Anspruch 6, dadurch gekennzeichnet, daß der Überzug eine leitende Elektrodenschicht zum Induzieren eines elektrischen Feldes in dem dünnen Film umfaßt, um die Anreicherungsschicht zu schaffen, und das Mittel zum Aufrechterhalten der Anreicherungsschicht weiter ein elektrisch vorspannendes Mittel umfaßt, das die leitende Elektrodenschicht mit den leitenden Teilen zusammenschaltet, die gegenüberliegenden Kanten des Erfassungsbereiches kontaktieren.

**8.** Ein Positionssensor nach Anspruch 6, dadurch gekennzeichnet, daß das Verhältnis der Zahnbreite zum Zahnabstand zwischen 0,17 und 0,37 beträgt.

**9.** Ein Positionssensor nach Anspruch 1, dadurch gekennzeichnet, daß die Schicht von magnetischem Material hoher Permeabilität eine ferromagnetische Schicht (24) ist, die über einer Oberfläche liegt; das magnetische Erfassungselement (16) längs der Breite der Oberfläche über der Schicht (24) zentriert ist, wobei die Breite des magnetischen Erfassungselementes (16) wesentlich kleiner als die Breite (W) des Magneten (22) ist; die Breite von jedem der Zähne (12A) weniger als die Breite von jeder der Lücken (12B) und mehr als die Breite des Erfassungselementes (16) ist; der dünne Film aus monokristallinem Indiumarsenid gebildet ist und einen allgemein rechteckigen Erfassungsbereich hat; es im wesentlichen parallele Leiter gibt, die den dünnen Film zum Injizieren von Stromträgern in gegenüberliegenden Kanten des Erfassungsbereiches kontaktieren; der Erfassungsbereich eine Abmessung in einem direkten Pfad zwischen den Leitern hat, die signifikant kürzer als ihre Abmessung parallel zu den Leitern ist, und die Dimensionen des Erfassungsbereiches weniger als die Breite des Erregerzahns (12A) sind.

**10.** Ein Positionssensor nach Anspruch 9, dadurch gekennzeichnet, daß das Erfassungselement (16) eine Vielzahl von Erfassungsbereichen hat, die Erfassungsbereiche sukzessive in einem länglichen Teil des dünnen Films angeordnet sind, wobei jeder Erfassungsbereich sich über die ganze Breite des länglichen Teils erstreckt, ein Leiter sich über die ganze Breite des länglichen Teils auf gegenüberliegenden Seiten von jedem Erfassungsbereich erstreckt und die Länge des länglichen Teils des Films eine Abmessung weniger als die Breite des Erregerzahns (12A) hat.

**Revendications**

**1.** Détecteur de position (20) qui comprend un circuit magnétique ayant une portion d'excitation (12) comprenant des dents (12A) séparées par des intervalles (12B) et une portion de détection pour détecter un déplacement relatif de la portion d'excitation par rapport à la portion de détection, dans lequel la portion de détection comprend un aimant permanent (22) ayant une surface au voisinage de la portion d'excitation (12) et étant relativement large en comparaison avec la largeur d'une dent d'excitation (12A), et un élément magnétique de détection (16) sur ledit aimant (22), caractérisé en ce qu'il existe une couche de matériau magnétique de perméabilité élevée (24) recouvrant entièrement ladite une surface, ledit élément magnétique de détection (16) est positionné sur ladite couche (24) le long d'une portion limitée intermédiaire entre les deux extrémités de l'aimant permanent (22), l'élément magnétique de détection (16) comprend un film mince d'un matériau semi-conducteur monocristallin d'une épaisseur d'environ 1-3 micromètres supportée par un substrat pratiquement isolant électriquement, ledit film mince ayant seulement une densité moyenne de porteurs de courant modérée, de l'ordre de $10^{16}$ électrons par centimètre cube, une mobilité moyenne de porteurs de courant modérée, d'au moins 10 000 $cm^2$ $volt^{-1}$ $seconde^{-1}$, et un intervalle de bande d'au moins 0,35 électronvolt ; une zone détectrice dans ledit film mince ; et une couche d'accumulation dans ledit film mince s'étendant à travers ladite zone détectrice et disposée adjacente à une surface dudit film mince, où lesdits porteurs de courant peuvent de préférence circuler entre des portions conductrices en contact avec des bords opposés de ladite zone détectrice.

**2.** Détecteur de position (20) selon la revendication 1, caractérisé en ce que ledit détecteur de position fournit des variations non amplifiées de niveau électrique de sortie de l'ordre d'un volt en réponse à des variations dans le champ magnétique appliqué sur une gamme de température de plusieurs centaines de degrés Celsius ; ledit aimant permanent (22) a une largeur (W) qui est au moins plusieurs fois plus grande que la largeur d'une dent d'excitation (12A), ledit film mince compris dans l'élément magnétique de détection (16) est un film mince en arséniure d'indium monocristallin (16) ayant des surfaces interne et externe, la surface interne étant supportée par un substrat en phosphure d'indium pratiquement isolant électriquement ; la zone détectrice dans ledit film en arséniure d'indium (16) est une zone détectrice sensiblement rectangulaire ayant un conducteur électrique s'étendant le long de la longueur de chaque bord long de la zone rectangulaire de détection ; et ledit film mince en arséniure d'indium (16) est non dopé nominalement et a une mobilité moyenne d'électrons d'environ 10 000 à 15 000 cm$^2$ volt$^{-1}$ seconde$^{-1}$, mais présente une sensibilité magnétique et une insensibilité à la température comme si le film en arséniure d'indium (16) était plus mince d'un ordre de grandeur au moins, avait une densité d'électrons supérieure d'au moins un ordre de grandeur et une mobilité sensiblement plus élevée.

3. Détecteur de position (20) selon la revendication 2, caractérisé en ce que la zone détectrice sensiblement rectangulaire a en outre une dimension de ses côtés courts qui représente environ 30 à 50 % de celle de ses côtés longs.

4. Détecteur de position (20) selon la revendication 2 ou 3, caractérisé en ce que la couche d'accumulation est une couche d'accumulation d'électrons adjacente à la surface externe dudit film en arséniure d'indium (16) qui s'étend entièrement sur la zone détectrice entre les conducteurs en contact avec ses côtés longs, et que cette couche d'accumulation a une densité d'électrons d'au moins un ordre de grandeur supérieure à ladite densité moyenne d'électrons et une mobilité d'électrons sensiblement supérieure à ladite mobilité moyenne d'électrons, afin de fournir ladite sensibilité magnétique et ladite gamme de température de fonctionnement.

5. Détecteur de position selon la revendication 1, caractérisé en ce que le matériau semi-conducteur du film mince est de l'arséniure d'indium, et que l'élément magnétique de détection (16) comprend un revêtement perméable à l'air sur le film mince en arséniure d'indium pour maintenir ladite couche d'accumulation dans ledit film pendant l'utilisation du détecteur de position sans nécessiter plus de deux contacts électriques audit élément de détection (16).

6. Détecteur de position selon la revendication 5, caractérisé en ce que la largeur (W) dudit aimant (22) est approximativement une fois et demie le pas de dent de la portion d'excitation (12), l'élément détecteur magnétorésistant (16) comprend une pluralité desdites zones détectrices à film mince, lesdites zones détectrices sont reliées électriquement en série les unes aux autres, et lesdites zones détectrices sont disposées dans une zone combinée ayant une dimension maximale inférieure à la largeur de ladite dent d'excitation (12A).

7. Détecteur de position selon la revendication 6, caractérisé en ce que le revêtement comprend une couche conductrice formant électrode pour produire un champ électrique dans le film mince afin de créer la couche d'accumulation, et les moyens pour maintenir la couche d'accumulation comprennent en outre des moyens de polarisation électrique reliant la couche conductrice formant électrode auxdites portions en contact avec les côtés opposés de ladite zone détectrice.

8. Détecteur de position selon la revendication 6, caractérisé en ce que le rapport de la largeur de dent au pas de dent est compris entre 0,17 et 0,37.

9. Détecteur de position selon la revendication 1, caractérisé en ce que la couche en matériau magnétique de perméabilité élevée est une couche ferromagnétique (24) recouvrant ladite une surface ; l'élément magnétique de détection (16) est centré le long de la largeur de ladite surface par dessus ladite couche (24), la largeur dudit élément magnétique de détection (16) étant sensiblement inférieure à la largeur (W) dudit aimant (22) ; la largeur de chacune desdites dents (12A) est inférieure à la largeur de chacun desdits intervalles (12B) et supérieure à la largeur dudit élément de détection (16) ; ledit film mince est formé d'arséniure d'indium monocristallin et présente une zone détectrice de forme générale rectangulaire ; il existe des conducteurs sensiblement parallèles entrant en contact avec ledit film mince pour injecter des porteurs de courant dans les bords opposés de ladite zone détectrice ; et ladite zone détectrice a une dimension en trajet direct entre lesdits conducteurs qui est sensiblement inférieure à sa dimension parallèle auxdits conducteurs, et les dimensions de ladite zone détectrice sont inférieures à la largeur de ladite dent d'excitation (12A).

10. Détecteur de position selon la revendication 9, caractérisé en ce que ledit élément de détection (16) a une pluralité de zones détectrices, les zones détectrices sont disposées successivement dans une portion allongée du film mince, avec chaque zone détectrice s'étendant sur toute la largeur de la portion allongée, un conducteur s'étend sur toute la largeur de la portion allongée sur des côtés opposés de chaque zone détectrice, et la longueur de la portion allongée du film a une valeur inférieure à la largeur de ladite dent d'excitation (12A).

# Fig.1a.

B=0

# Fig.1b.

B
⊚

# Fig.2.

Metal

Contact

Electrons

Semiconductor
Epitaxial Layer

Contact

Insulating
Substrate

High Mobility
Semiconductor
Layer

Magnetic Field

Fig. 3.

EP 0 357 199 B1

Fig.4.

Magnetoresitor   InAs/Inp
SENSITIVITY AT 0.4  TELSA

Fig.5.

Magnetoresistor  InAs/InP

22

## Fig.6.

## Fig. 7a.

## Fig.7b.

Fig.8.

Fig. 9.

Fig. 10.

*Fig.11a.*

*Fig.11b.*

*Fig.11c.*

*Fig.12.*

26

(PRIOR ART)

Fig.13.

Fig.14.

Fig.15.

*Fig.16A.*

*Fig.16B.*

Fig.17.

MAXIMUM MAGNETIC SENSITIVITY $S_{mMAX}$(%)

NORMALIZED DISTANCE d/W

Fig.18.

MAGNETIC SENSITIVITY $S_m$ (%)

NORMALIZED DISTANCE d/W